**Europäisches Patentamt**

**European Patent Office**

**Office européen des brevets**

(19)

(11) Publication number: **0 033 434**

**A1**

(12) # EUROPEAN PATENT APPLICATION

(21) Application number: **80830101.4**

(22) Date of filing: **27.11.80**

(51) Int. Cl.³: **H 03 J 9/00**

(30) Priority: **31.01.80 IT 1958080**

(43) Date of publication of application:
**12.08.81 Bulletin 81/32**

(84) Designated Contracting States:
**AT BE CH DE FR GB LI NL**

(71) Applicant: **BRIONVEGA S.p.A.**
**Via Pordenone, 8**
**I-20132 Milano(IT)**

(72) Inventor: **Raffaello, Pini**
**Via Volturno, 80 Meridiana 721**
**Brugherio (Milano)(IT)**

(74) Representative: **Zini, Alessandro**
**Ufficio Tecnico Internazionale Brevetti Ing. Alessandro**
**Zini Piazza Castello 1**
**I-20121 Milano(IT)**

(54) An arrangement for remotely switching over two or more antenna taps of a television set.

(57) The arrangement comprises a telecontrol and a circuit adapted to receive the signals emitted by the telecontrol transmitter and to effect in dependance thereon the switching over between two or more antennas.

This circuit consists in its simplest configuration of two antenna taps, each followed by a transistor stage through two diodes leading to a single output to be connected to the antenna tap of the television set.

The two transistor stages and the two diodes are alternatively driven on or off so that when the signal from the one antenna passes freely the signal from the other antenna is cut off.

The voltages for driving the one stage on and the other stage off respectively, are provided by a control logic driven by a telecontrol signal which can be an already existing signal intended for other functions.

./...

FIG.1

<u>An arrangement for remotely switching over two or more an-</u>
<u>tenna taps of a television set.</u>

The present invention refers to an arrangement for remotely switching over two or more antenna taps of a television
set.

The growing up of a number of private transmitting stations
in the UHF band has made it very problematic and sometimes
impossible to convey all these signals in the single preex
isting antenna system, generally a centralized antenna
system. Therefore, for the reception of these private television stations the users have recourse usually to a second separate antenna in the UHF band. The performance of
the present day television sets provided with a telecontrol
for the channel switching are therefore partly limited because of the requirement to change the antenna connected
to the input of the television set when switching over from
one station to another, which operation has been made heretofore manually.

It is an object of the present invention to overcome this
disadvantage.

More particularly the arrangement according to the invention
for remotely switching over two or more antenna taps of a
television set is characterized in that it comprises a telecontrol transmitter and a circuit comprising a receiver
for the signals emitted by the telecontrol transmitter and an electronic antenna switch having a first set of two or more inputs connected to corresponding outputs of the control logic and a second set of two or more inputs connected to two or more antenna taps, as well as an output connected to the radio frequency stage of the television set.

By means of the above said arrangement it is possible to remotely switch over two or more antenna taps of a television set without the need of any manual assistance.

The telecontrol transmitter for the antenna switching can be advantageously incorporated in the same telecontrol transmitter used for switching over the channels of the television set.

The invention will be better understood from the following description, given merely as an example and therefore in no limiting sense, of an embodiment thereof, referring to the accompanying drawings in which:

Fig. 1 is a block diagram of an arrangement according to the invention; and

Fig. 2 is a wiring diagram of a part of the arrangement of Fig. 1.

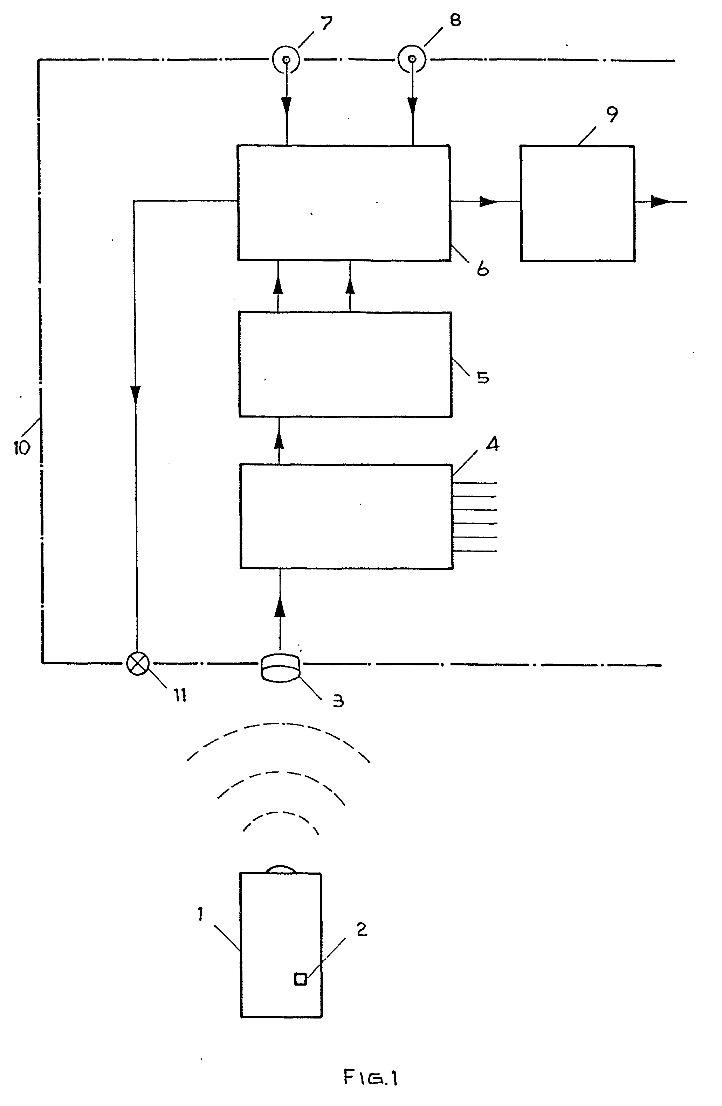

Referring first to Fig. 1, it is seen that incorporated in a conventional telecontrol transmitter 1 intended for switching over the channels and controlling the various parameters of the television set is a key 2 for controlling the switching of the antennas.

The circuit intended to be controlled by the key 2 comprises a sensor 3 of the telecontrol signal for the antennas, a telecontrol receiver 4 having its input connected to the output of the sensor 3, a control logic 5 having its input connected to the output of the telecontrol receiver, and an electronic antenna switch 6 having two inputs connected to two corresponding outputs of the control logic and two further inputs connected to two antenna taps 7 (main antenna) and 8 (secondary antenna) and an output connected to the radio frequency section 9 of a television set 10 indicated generally diagrammatically with phantom lines. A second output of the electronic switch is connected to a lamp 11 indicating that the television set is switched on the secondary antenna.

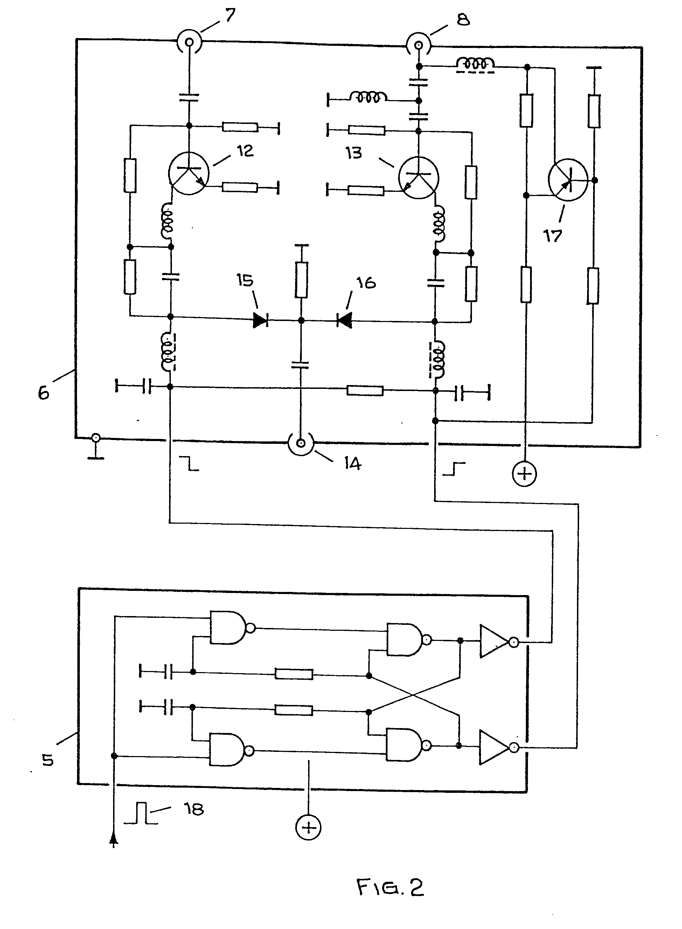

Fig. 2 shows the wiring diagram of the control logic and the electronic antenna switch. The control logic 5 is of a conventional type and therefore it will not be described in detail.

The electronic antenna switch 6 comprises two transistor stages 12 and 13 and two diodes 15 and 16. The collectors of the two transistors are connected through the two diodes 15 and 16 to the antenna tap 14 of the television set.

Assuming that the television set is pre-arranged for operation with the main VHF/UHF antenna connected to the tap 7, if it is desired to switch over to the secondary antenna connected to the tap 8 it is sufficient to push down the key 2 of the telecontrol transmitter 1. The telecontrol signal 18 drives the logic 5 which supplies such a bias voltages to the transistor stages 12 and 13 and the diodes 15 and 16 as to drive the transistor stage 13 on and the stage 12 off. There is thus established the connection between the antenna tap 14 of the television set and the antenna tap 8 and is cut off the connection between the tap 14 and the antenna tap 7. The television set is thus prearranged for operation with the secondary UHF antenna connected to the tap 8. Signals from the secondary antenna pass now freely whereas those from the main antenna are cut off.

In the ciruit shown as an example in the accompanying diagram, when the circuit connected to the antenna 8 is in operation also a direct current voltage protected against short circuit by the transistor 17 appears across the terminals of said tap. This enables to connect to this tap and to feed from it without further connections, also a purposely provided amplified antenna, whose incorporated amplifier is fed directly from the feeder of the television set through the same antenna connection.

In television sets provided with more sophisticated telecontrols equipped with microprocessors, it is possible to make this switching between antennas fully automatic, program by program, according to what has been established once and for all at the programming of the television set. In such a case the telecontrol transmitter needs not be provided with a special key for the antenna switching.

The device comprising the telecontrol receiver, the control logic and the electronic antenna switch can be incorporated directly in the television set, as in the described example, or also be an external appliance for suitably prearranged television sets.

The device can also be used for remotely controlling the operation of the television set on radiated signals or a video-recorder or telegames or any source of television signals permanently connected to the antenna taps.

By increasing the number of the transistor stages and changing the control logic it is possible to cyclically switch over a higher number of antenna taps.

Generally, while but one embodiment of the invention has been illustrated and described, it is obvious that a number of changes and modifications can be made without departing from the scope of the invention.

0033434

Claims

1. An arrangement for remotely switching over two or more antenna taps of a television set, characterized in that it comprises a telecontrol transmitter and a circuit comprising a receiver for the signals emitted by the telecontrol transmitter and an electronic antenna switch having a first set of two or more inputs connected to corresponding outputs of the control logic and a second set of two or more inputs connected to two or more antenna taps, as well as an output connected to the radio frequency stage of the television set.

2. An arrangement as claimed in claim 1, characterized in that the electronic antenna switch comprises for each antenna tap a transistor stage connected between said tap and an output corresponding to the control logic.

3. An arrangement as claimed in claim 1 or 2, characterized in that the telecontrol transmitter is incorporated in the conventional telecontrol transmitter of the television set for switching over the channels and controlling parameters of the television set.

4. An arrangement as claimed in any of claims 1 to 3, characterized in that the circuit for receiving the telecontrol signals and switching over the antenna is incorporated in the television set.

5. An arrangement as claimed in any of claims 1 to 4, characterized in that an antenna tap is connected, through a protective transistor, to the feeder of the television set.

0033434

Fig.1

FIG.2

# EUROPEAN SEARCH REPORT

European Patent
Office

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| | US - A - 4 078 236 (HEMPELL)<br><br>  * Figure 4; column 4, line 27 -<br>    column 5, line 36 *<br><br>      -- | 1,3,4 | H 03 J 9/00 |
| | US - A - 3 949 297 (HIDESHIMA)<br><br>  * Figure 2; column 4, lines 12-<br>    51 *<br><br>      -- | 1 | |
| | US - A - 3 056 961 (MITCHELL)<br><br>  * Figure 5; column 4, lines 29-<br>    35; column 5, lines 28-39 *<br><br>      ---- | 1,2 | **TECHNICAL FIELDS SEARCHED (Int. Cl.³)**<br><br>H 03 J 9/00<br>         9/02<br>         9/04<br>         9/06<br>H 01 Q 3/24<br>         5/00 |

**CATEGORY OF CITED DOCUMENTS**

X: particularly relevant
A: technological background
O: non-written disclosure
P: intermediate document
T: theory or principle underlying
   the invention
E: conflicting application
D: document cited in the
   application
L: citation for other reasons

&: member of the same patent
   family,
   corresponding document

The present search report has been drawn up for all claims

| Place of search | Date of completion of the search | Examiner |
|---|---|---|
| The Hague | 08-05-1981 | LEDRUT |

EPO Form 1503.1  06.78